# EUROPEAN PATENT APPLICATION

(11) **EP 4 818 727 A1**
(43) Date of publication of application: **07.10.2026**
(21) Application number: 26168930.1
(22) Date of filing: 30.03.2026
(51) Int. Cl.: G01R 31/396, B60L 58/10, G01R 31/367, G01R 31/392, G01R 31/3842, H02J 7/54

(54) **APPARATUS AND METHOD FOR DIAGNOSING BATTERY CONDITION**

(30) Priority: 03.04.2025 KR 20250043718
(71) Applicant: SAMSUNG SDI CO., LTD., Yongin-si, Gyeonggi-do 17084 (KR)
(72) Inventor: Alekseev, Aleksandr, Yongin-si, Gyeonggi-do 17084 (KR)
(74) Representative: Meissner Bolte Partnerschaft mbB

(57) **Abstract**

The present invention relates to a battery diagnosis apparatus (20) and method for diagnosing or detecting a condition of a battery. A battery diagnosis apparatus (20) according to an embodiment may include: a measuring device (22) for measuring a first current value (Im) flowing through a charging-discharging path of a plurality of battery cells (11) and a cell voltage value (Ut) of at least one of the plurality of battery cells (11); and at least one processor configured to estimate a second current value (Ib) flowing through a balancing resistor (Rb) connected to the at least one of the plurality of battery cells (11) based on the cell voltage value, estimate a third current value (Ip) flowing through an internal short-circuit resistance (Ri) of the at least one of the plurality of battery cells (11) based on the first current value, the second current value, and a change in charge state of the at least one of the plurality of battery cells (11), and detect an abnormal cell among the plurality of battery cells (11) based on the third current value of the at least one of the plurality of battery cells (11).

## Description

### BACKGROUND

### 1. Field

The present invention relates to an apparatus and method for diagnosing a battery.

### 2. Description of the Related Art

Rechargeable batteries are capable of being repeatedly charged and discharged, unlike primary batteries that cannot be recharged. Low-capacity rechargeable batteries may be used in small portable electronic devices, such as smart phones, feature phones, laptop computers, digital cameras, and camcorders, while large-capacity rechargeable batteries may be used as power sources for driving motors in hybrid vehicles, electric vehicles, and as electric power storage devices (e.g., home and/or utility scale power storage). The rechargeable batteries generally include an electrode assembly consisting of a positive electrode and a negative electrode, a case to accommodate the electrode assembly, and an electrode terminal connected to the electrode assembly.

In regards to rechargeable batteries, an internal short-circuit where the positive and negative electrodes inside the cell are short-circuited may occur due to malfunction of a separator. The internal short-circuit may cause safety problems such as thermal runaway.

The above-described information disclosed in the background art of this invention is only for better understanding of the background of the present invention and thus may include information that does not constitute conventional art.

### SUMMARY

The present invention is directed to an apparatus and method for diagnosing a battery that may be applied (e.g., flexibly applied) in one or more conditions or environments such as, for example, when there are changes in the battery or in the system environment where the battery is applied. The battery diagnosis apparatus and method may diagnose or detect abnormal cells (e.g., in real time).

However, the technical object to be solved by the present invention is not limited to the above-described problems, and other problems not mentioned can be clearly understood by a person of an ordinary skill in the art from the description of the invention described below.

One aspect of the present invention for solving the technical object relates to an apparatus for diagnosing a battery (also referred to as a battery diagnosis apparatus). The battery diagnosis apparatus according to the invention includes: a measuring device configured to measure a first current value flowing through a charging-discharging path of a plurality of battery cells and a cell voltage value of at least one of the plurality of battery cells; and at least one processor configured to estimate a second current value flowing through a balancing resistor connected to the at least one of the plurality of battery cells based on the cell voltage value, estimate a third current value flowing through an internal short-circuit resistance of the at least one of the plurality of battery cells based on the first current value, the second current value, and a change in charge state of the at least one of the plurality of battery cells, and detect an abnormal cell among the plurality of battery cells based on the third current value of the at least one of the plurality of battery cells.

The at least one processor may be configured to derive a linear regression model for estimating the third current value based on obtaining the first current value, the second current value, and the change of the charge state during a set interval, and may be further configured to estimate the third current value based on the linear regression model.

The at least one processor may be configured to derive one or more coefficients of the linear regression model based on a least squares method.

The at least one processor can detect an abnormal value based on statistical analysis of the third current value, and determine the at least one of the plurality of battery cells for which the abnormal value is detected as the abnormal cell.

The at least one processor may calculate an average cell voltage value for a set period for the at least one of the plurality of battery cells, and calculate a second resistance value of the internal short-circuit resistance for the at least one of the plurality of battery cells based on the average cell voltage value and the third current value of the at least one of the plurality of battery cells.

The at least one processor may detect an abnormal value based on a statistical analysis of the second resistance value of the at least one of the plurality of battery cells, and determine the at least one of the plurality of battery cells for which the abnormal value is detected as the abnormal cell.

The at least one processor may be configured to: detect an abnormal value through statistical analysis of the average cell voltage value of the at least one of the plurality of battery cells, and determine the at least one of the plurality of battery cells for which the abnormal value is detected as an abnormal cell.

The at least one processor is configured to estimate a capacity value of the at least one of the plurality of battery cells based on the linear regression model, statistically analyze the capacity value of the at least one of the plurality of battery cells to detect an abnormal value, and determine the at least one of the plurality of battery cells for which the abnormal value is detected as the abnormal cell.

The battery diagnosis apparatus may further include a storage device storing a table representing a relationship between an open circuit voltage (OCV) and a charge state. The at least one processor may be configured to determine the cell voltage value based on the at least one of the plurality of battery cells having the first current value less than or equal to a threshold value for at least an identified amount of time, as the open circuit voltage (OCV) of the at least one of the plurality of battery cells. The at least one processor may estimate a charge state value of the at least one of the plurality of battery cells based on the open circuit voltage (OCV) of the at least one of the plurality of battery cells and the table, and calculate the change of the charge state based on the charge state value.

The at least one processor may be included in a battery management system of a battery system having at least one of the plurality of battery cells.

The at least one processor may include a first processor configured to estimate the third current value and a second processor configured to detect the abnormal cell. The first processor may be included in a battery management system of a battery system having at least one of the plurality of battery cells. The second processor may be included in an external device of the battery system.

Another aspect of the present invention relates to a method for diagnosing a battery (referred to as a battery diagnosis method) performed by at least one processor, where the battery diagnosis method according to an the invention includes: measuring a first current value flowing in a charging-discharging path of a plurality of battery cells and a cell voltage value of at least one of the plurality of battery cells; estimating a second current value flowing through a balancing resistor connected to the at least one of the plurality of battery cells based on the cell voltage values; estimating a third current value flowing through an internal short-circuit resistance of the at least one of the plurality of battery cells based on the first current value, the second current value, and a change in charge state of the at least one of the plurality of battery cells; and detecting an abnormal cell of the at least one of the plurality of battery cells based on the third current value of the at least one of the plurality of battery cells.

The estimating the third current value may include: deriving a linear regression model for estimating the third current value based on the first current value, the second current value, and the change of the charge state obtained during a set period; and estimating the third current value based on the linear regression model.

The deriving the linear regression model may include deriving one or more coefficients of the linear regression model based on a least squares method.

The detecting of the abnormal cell may include: detecting an abnormal value based on a statistical analysis of the third current value; and determining the at least one of the plurality of battery cells for which the abnormal value is detected as an abnormal cell.

The battery diagnosis method may further include: calculating an average cell voltage value for a set period for the at least one of the plurality of battery cells; and calculating second resistance value of the internal short-circuit resistance for the at least one of the plurality of battery cells based on the average cell voltage value and the third current value of the at least one of the plurality of battery cells.

The battery diagnosis method may further include: detecting an abnormal value based on a statistical analysis of the second resistance value of the at least one of the plurality of battery cells; and determining the at least one of the plurality of battery cells for which the abnormal value is detected as an abnormal cell.

The battery diagnosis method may further include: detecting an abnormal value based on a statistical analysis of the average cell voltage value of the at least one of the plurality of battery cells; and determining the at least one of the plurality of battery cells for which the abnormal value is detected as an abnormal cell.

The battery diagnosis method may further include: estimating a capacity value of the at least one of the plurality of battery cells based on the linear regression model; statistically analyzing the capacity value of the at least one of the plurality of battery cells to detect an abnormal value; and determining the at least one of the plurality of battery cells for which the abnormal value is detected as the abnormal cell.

The battery diagnosis method may further include: determining a cell voltage value based on the at least one of the plurality of battery cells having the first current value lower than or equal to a threshold value for at least an identified amount of time, as an open circuit voltage (OCV) of the at least one of the plurality of battery cells; estimating a charge state value of the at least one of the plurality of battery cells based on a table representing a relationship between the open circuit voltage (OCV) and a charge state and the open circuit voltage (OCV) of the at least one of the plurality of battery cells; and calculating the change of the charge state based on the charge state value.

According to one or more embodiments of the present invention, a battery diagnosis apparatus and method is provided that may be applied (e.g., flexibly applied) in spite of changes in battery or system environment where the battery is applied, and that may be capable of diagnosing abnormal cells (e.g., in real time).

However, the effects achieved by the present invention are not limited to the above-described effects, and other technical effects not mentioned above can be clearly understood by a person of an ordinary skill in the art from the description of the invention described below.

### BRIEF DESCRIPTION OF THE DRAWINGS

The following drawings attached to this specification illustrate one or more embodiments of the present invention, and facilitate better understanding of the technical idea of the present invention together with the detailed description of the invention described below, and therefore, the present invention should not be interpreted as being limited to the matters described in such drawings.
FIG. 1 depicts a block diagram of a battery diagnosis apparatus according to an embodiment of the present invention.
FIG. 2 depicts a schematic diagram of a passive typed balancing circuit according to an embodiment of the present invention.
FIG. 3 depicts a schematic diagram of current flow in a battery cell according to an embodiment of the present invention.
FIG. 4 depicts a flow diagram of a battery diagnosis method executed by a battery diagnosis apparatus according to an embodiment of the present invention.

### DETAILED DESCRIPTION

Hereinafter, one or more embodiments of the present invention are described in detail with reference to the attached drawings. The terms or words used in this specification and claims should not be interpreted as limited to their usual or dictionary meanings, but should be interpreted as meanings and concepts that conform to the technical idea of the present invention, based on the principle that an inventor be his/her own lexicographer to properly define the concept of a term to explain his or her own invention in the best way. Accordingly, the embodiments described in this specification and the configurations illustrated in the drawings are only examples of embodiments of the present invention and do not represent all the technical ideas, aspects, and features of the present invention. Accordingly, it should be understood that there may be various equivalents and modified examples that can replace or modify them at the time of this application.

A person of ordinary skill in the art would appreciate, in view of the present invention in its entirety, that a feature of embodiments of the present invention may be combined or combined with one or more other features, partially or entirely, and may be technically interlocked and operated in various suitable ways, and an embodiment may be implemented independently of one or more other embodiments, or in conjunction with the one or more other embodiments in a suitable manner, unless expressly stated or implied otherwise.

Also, in this specification, "comprise," "include," "comprising," or "including" is used for specifying the presence of the shapes, numbers, steps, operations, members, elements, and/or groups thereof, but not for precluding the presence or addition of one or more other shapes, numbers, operations, members, elements and/or groups. Also, when describing embodiments of the present invention, "can" and "be able to" may include "one or more embodiment of the present invention."

Additionally, the attached drawings may not be drawn to actual scale and dimensions of some components may be exaggerated in order to facilitate understanding of the invention. Additionally, the same reference number may be assigned to the same component in different embodiments.

When two things being compared are 'same', it means that they are 'substantially same.'

Therefore, being substantially same may include a state having deviations that are considered low in the art, for example, deviations of less than 5%. Additionally, when a parameter is said to be uniform in a region, it may mean that the parameter is uniform from an average perspective.

Although ordinal terms such as "first", "second", etc. may be used to describe various elements, these elements are not limited by these terms. These terms are only used to distinguish one component from another, and unless otherwise stated, the "first" component may be the "second" component.

Throughout the specification, unless otherwise specifically stated, each component may be singular or plural. For example, the singular forms "a" and "an" are intended to include the plural forms as well, unless the context clearly indicates otherwise.

When a component is said to be disposed, located, arranged, or positioned "on (or under)" or "above (or below)" other component, it means not only that the component is disposed, located, arranged, or positioned to contact a upper surface (or lower surface) of the other component but also that some other components may be interposed therebetween.

In addition, spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Additionally, when it is described that a component, element, or layer (collective referenced as "component") is "on," "connected to," "coupled to" or "accessed by" another component, it should be understood not only that the components may be directly on, connected, coupled, or accessed to the other component, but also that other components may be "interposed" between the components, or components may be "on," "connected to," "coupled to," or "accessed by" through another component. Also, when it is described that a part is electrically connected (electrically coupled) to another part, this includes not only cases where they are directly connected, but also cases where they are connected with another element therebetween.

Throughout the specification, "A and/or B" means A, B or A and B, unless otherwise specified. That is, "and/or" includes all combinations or any combination of the listed plurality of items. "C to D" means C or more and D or less, unless otherwise specified.

As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

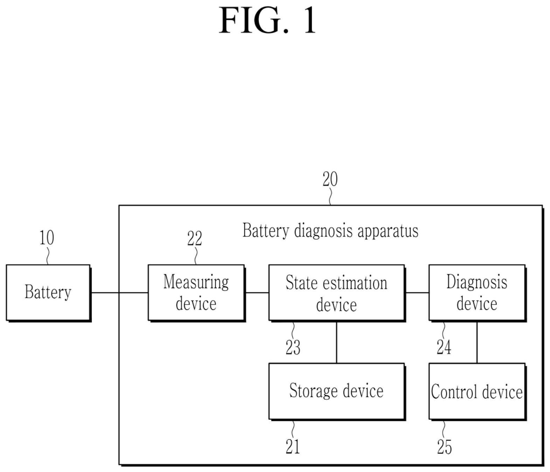

FIG. 1 depicts a block diagram of a battery diagnosis apparatus according to an embodiment.

Referring to FIG. 1, the battery 10 may include a plurality of battery cells (not shown) electrically connected in series one another.

The battery diagnosis apparatus 20 collects measurement data of the battery 10, estimates the state of the battery 10 based on the collected measurement data, and detects abnormal cells among the plurality of battery cells through statistical analysis of the state estimation result and the measurement data. In some embodiments, the battery diagnosis apparatus 20 may include a storage device 21, a measuring device 22, a state estimation device 23, a diagnosis device 24, and a control device 25.

The storage device 21 may contain or store data, information, and/or the like processed by the battery diagnosis apparatus 20. The storage device 21 may store a lookup table (hereinafter referred to as 'SOC-OCV table') indicating the relationship between an open circuit voltage (OCV) and the state of charge (SOC) of the battery cell. A SOC-OCV table may contain one or more different OCV values (or OCV ranges) and a SOC value respectively corresponding to the OCV value (or the OCV range). The SOC-OCV table may be stored in the storage device 21 after the values have been identified through experiment or simulation during a design or manufacturing stage of the battery 10. For example, the SOC-OCV table may be generated through a GITT (Galvanostatic Intermittent Titration Technique) test and then stored in storage device 21.

The storage device 21 may also store a program for the operation of at least one of the state estimation device 23 and the diagnosis device 24 described below.

The storage device 21 may include at least one memory. The memory may be a readable recording medium in a computing device, and may include various types of volatile or non-volatile recording medium. For example, the memory may include various types of recording medium, such as flash memory type, hard disk type, card type (e.g., SD or XD memory), Random Access Memory (RAM), Static Random Access Memory (SRAM), Read-Only Memory (ROM), (Electrically Erasable Programmable Read-Only Memory (EEPROM), Programmable Read-Only Memory (PROM), and the like.

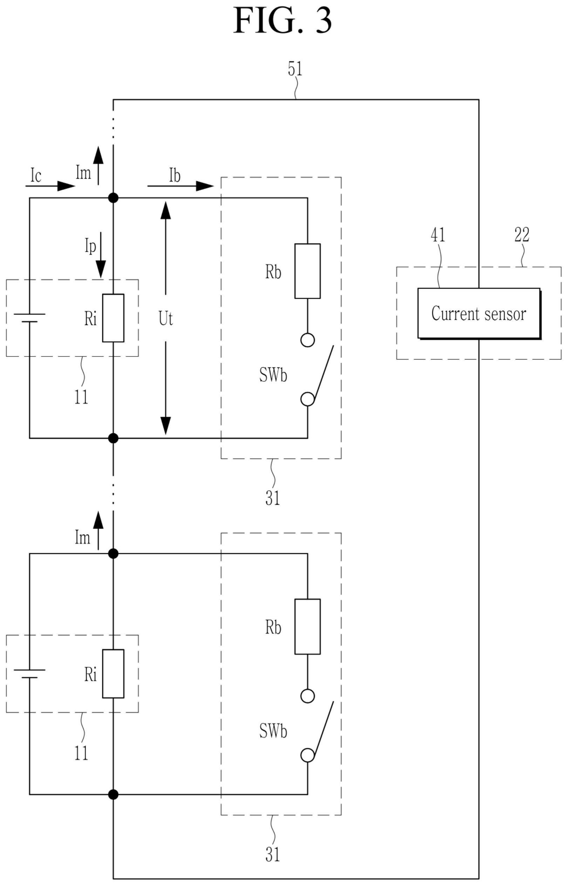

The measuring device 22 may measure the state (current, voltage, and/or temperature) of the battery 10. The measuring device 22 may include a sensor or measurement circuit for measuring the state of the battery 10. The measuring device 22 may include a voltage measurement circuit for measuring the voltage of at least one (e.g., each) battery cell constituting the battery 10 (hereinafter, referred to as "cell voltage"). The measuring device 22 may include a current sensor (e.g., a shunt resistor, Hall effect sensor, and/or the like) (see reference numeral 41 of FIG. 3 described below) for measuring the current flowing through the battery 10. The measuring device 22 may measure (e.g., continuously measure) the state of the battery 10 and may transmit measurement data (e.g., cell voltage value, charging and discharging current value, and/or the like) obtained via measurement of the state, to the state estimation device 23 described below. The measuring device 22 may transmit measurement data to the state estimation device 23 using wired communication such as UART (Universal Asynchronous Receiver-Transmitter), CAN (Controller Area Network), Ethernet Local Area Network (LAN), SPI (Serial Peripheral Interface), I2C (Inter-Integrated Circuit), and the like, or wireless communication such as WI-FI, Bluetooth, and the like.

The state estimation device 23 may estimate the state, such as OCV, SOC, balancing current, capacity, parasitic leakage current, internal short-circuit resistance, and the like, of the battery cells constituting battery 10 using the measurement data received from the measuring device 22.

The state estimation device 23 may estimate the OCV value of a battery cell (e.g, each battery cell) by using the cell voltage value of the battery cell measured in a state that satisfies an identified (e.g., a predetermined) condition. If the battery cell is associated with a state in which the current flowing through the battery cell is lower than or equal to a current threshold value (including an idle state in which no current flows through the battery cell), and the state continues for a threshold period or longer, the state estimation device 23 may determine the OCV value of the battery cell using the cell voltage value of the battery cell measured in the state. In some embodiments, the current threshold value and threshold period are reference values for determining whether the voltage loss due to the polarization phenomenon of the battery cell has stabilized below a certain level, and the values may be determined in advance during a stage of designing or manufacturing the battery 10 and stored in the storage device 21.

The state estimation device 23 may estimate the SOC value of a battery cell (e.g., each battery cell) using the SOC-OCV table based on the OCV value of the battery cell being determined. Based on the OCV value of the battery cell being determined, the state estimation device 23 may determine the SOC value of the battery cell by searching for a corresponding SOC value from the SOC-OCV table. If a SOC value matching the OCV value of the battery cell is not found in the SOC-OCV table, the state estimation device 23 may determine the SOC value of the battery cell by a method such as interpolation using similar SOC values.

The state estimation device 23 may also estimate the balancing current value of the battery cell based on the cell voltage value of the battery cell measured through the measuring device 22.

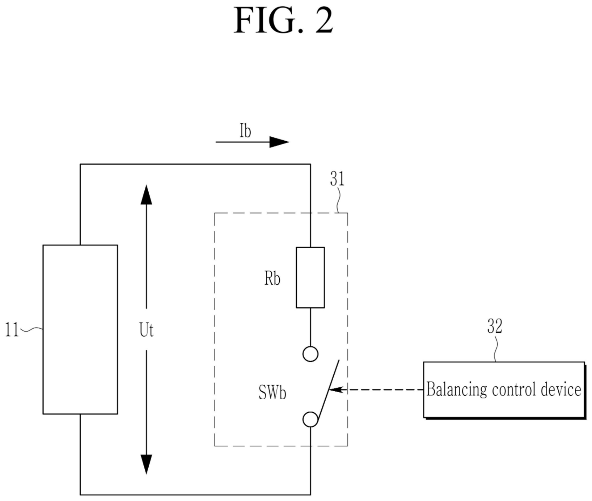

FIG. 2 depicts a schematic diagram of a passive typed balancing circuit according to an embodiment of the present invention. Referring to FIG. 2, the balancing circuit 31 of a battery cell (e.g., each battery cell) 11 may be electrically connected in parallel with the battery cell 11. The balancing circuit 31 may include a balancing resistor Rb and a balancing switch SWb that are electrically connected in series with each other. The balancing switch SWb may be controlled to an on-state (closed state) or off-state (open state) by the balancing control device 32. Based on the balancing switch SWb being turned on, a current path flowing through the balancing resistor Rb and the balancing switch SWb may be formed, and the battery cell may be discharged through the current path. The balancing control device 32 may determine a target balancing amount of the battery cell 11 based on the cell voltage value or SOC value of the battery cell 11. Based on the target balancing amount being determined, the balancing control device 32 may control the balancing switch SWb of the balancing circuit 31 so that the battery cell 11 is discharged by the target balancing amount.

Referring to FIG. 2, the balancing current value (Ib(t)) may be calculated based on the cell voltage value (Ut(t)) of the battery cell and the balancing resistor value (Rb) of the balancing circuit 31, as shown in equation 1 below. $Ib \left(t\right) = \frac{Ut \left(t\right)}{Rb} ρ \left(t\right)$ equation 1

In the above equation 1, Ut(t) may be a present or an instantaneous voltage value of the battery cell measured at a selected or an arbitrary measurement moment. In this case, the balancing current Ib(t) may be a present or an instantaneous current flowing through the battery cell at the corresponding moment. Ut(t) may be an average value of cell voltage values measured from a battery cell during a selected or an arbitrary measurement interval. In this case, the balancing current Ib(t) may be an average value of the balancing current flowing through the balancing circuit 31 during the corresponding measurement interval. In equation 1 above, Rb represents a resistance value of the balancing resistor Rb. In some embodiments, Rb may be a fixed value.

In equation 1 above, ρ(t) is a correction factor. The value of ρ(t) may vary depending on parameters that affect the flow of balancing current Ib(t) (e.g., on/off state of the balancing switch SWb, on resistance of the balancing switch SWb, on/off duty cycle of the balancing switch SWb, and the like) other than the balancing resistor Rb. When the balancing switch SWb is off, the correction factor ρ(t) may have a value of 0. When the balancing switch SWb is on, the correction factor ρ(t) may have a value of 0 < ρ≤1.

In some embodiments, the resistance value Rb and correction factor ρ(t) of the balancing resistor for equation 1 are determined according to the hardware design specifications of the balancing circuit 31, and the value may be determined in advance when designing the balancing circuit 31 and stored in the storage device 21.

Referring to FIG. 1 again, the state estimation device 23 may estimate the balancing current value Ib(t) of a battery cell (e.g., each battery cell) using the received cell voltage value and equation 1 above based on receiving the cell voltage value of the battery cell from the measuring device 22.

In some embodiments, the state estimation device 23 may estimate a capacity value and a parasitic leakage current value of a battery cell (e.g., each battery cell) by using the measurement data (current value, cell voltage value, and/or the like) received from the measuring device 22, and the SOC value and balancing current value Ib(t) of the battery cell. In this invention, the capacity of a battery cell may refer to a total capacity of the battery cell, (e.g., a total amount of charge that the battery cell can store and supply). Additionally, the parasitic leakage current (or simply leakage current) may represent current that leaks through the internal short-circuit resistance of the battery cell.

FIG. 3 depicts a schematic diagram of current flow in a battery cell according to an embodiment of the present invention.

Referring to FIG. 3, the current Ic flowing through a battery cell 11 (hereinafter, referred to as "cell current") may include a measured current component Im measured by a current sensor 41 of the measuring device 22. The current sensor 41 may be positioned in the charging-discharging path 51 between the battery cells 11 and an external device (e.g., a charger, load, and/or like) that receives electric energy from or supplies electric energy with the battery cells 11 that are electrically connected in series with each other. The current sensor 41 may measure the current Im flowing through the charging-discharging path. The cell current Ic flowing through the battery cell 11 may, in addition to the measured current component Im, further include a parasitic leakage current component Ip flowing through the internal short-circuit resistance Ri within the battery cell 11 and a balancing current component Ib flowing through the balancing circuit 31. In some embodiments, the cell current Ic of battery cell 11 can be expressed as a vector sum of the balancing current Ib flowing through the balancing resistor Rb, the parasitic leakage current Ip flowing through the internal short-circuit resistance Ri of battery cell 11, and the measured current Im measured through the measuring device 22, using equation 2 below. The vector sum may refer to a method of summing that takes magnitudes and directions into account. $Ic \left(t\right) = Im \left(t\right) + Ip + Ib \left(t\right)$ equation 2

In the above equation 2, the cell current value Ic(t), the measured current value Im(t), and the balancing current value Ib(t) are assumed to vary with time t, and the parasitic leakage current value Ip is assumed to have a constant value.

Based on the above equation 2, the relationship between the SOC of battery cell 11 and each of the current components (e.g., the balancing current Ib, parasitic leakage current Ip, and measured current Im) can be expressed by the following equation 3. $\frac{dSOC \left(t\right)}{dt} = \frac{1}{Q} \times Ic \left(t\right) = \frac{1}{Q} \left(Im\left(t\right)+Ip+Ib\left(t\right)\right)$ equation 3

In the above equation 3, Q may represent a capacity value of the battery cell.

Based on the above equation 3, the relationship between the SOC change (SOC(t2) - SOC(t1)) between two different time points t1 and t2 and each of the current components (balancing current Ib, parasitic leakage current Ip, and measured current Im) can be expressed using the following equation 4. $SOC \left(t2\right) - SOC \left(t1\right) = \frac{1}{Q} {\int }_{t 1}^{t 2} \left(Im\left(t\right)+Ib\left(t\right)\right) dt + \frac{{I}_{p}}{Q} \left(t2-t1\right)$ equation 4

Referring to FIG. 1 again, the state estimation device 23 may collect data (e.g., continuously collect data) associated with the SOC, measured current Im, and balancing current Ib of at least one (e.g., each) battery cell 11 during an identified or a predetermined observation period. In some embodiments, the state estimation device 23 may estimate the capacity value Q and parasitic leakage current value Ip of at least one (e.g., each) battery cell using the data collected during the observation period, the equation 4 above, and the least squares method. In some embodiments, the state estimation device 23 derives a linear regression model for estimating the capacity value Q and parasitic leakage current value Ip for at least one (e.g., each) battery cell 11 during the observation period using the data collected during the observation period (e.g., the SOC value, measured current value Im(t), and balancing current value Ib(t)) and the above equation 4, and may determine the coefficients that satisfy a criterion (e.g., optimal coefficients) of the linear regression model using the least squares method. In some embodiments, the state estimation device 23 may estimate the capacity value Q and parasitic leakage current value Ip of at least one (e.g., each) battery cell 11 during the observation period using the derived linear regression model.

Based on estimating the parasitic leakage current value Ip of the at least one (e.g., each) battery cell 11, the state estimation device 23 may also estimate the internal short-circuit resistance value of the battery cell 11 using the estimated parasitic leakage current value. Referring to FIG. 3, the internal short-circuit resistance value of the battery cell 11 may be calculated using the cell voltage Ut(t) and parasitic leakage current Ip of the corresponding battery cell 11, as in the following equation 5. $\overline{Ri} = \frac{\overline{Ut}}{Ip}$ equation 5

In the above equation 5, U̅t̅ is a cell voltage during the observation period for which data was collected to estimate the parasitic leakage current Ip, and may correspond to an average value of the cell voltage values Ut measured from the corresponding battery cell 11 during the observation period. Therefore, R̅l̅ may be an average value of the internal short-circuit resistance value Ri during the observation period of the battery cell 11.

The diagnosis device 24 may detect abnormal cells through statistical analysis of the state data (e.g., cell voltage value, capacity value, parasitic leakage current value, internal short-circuit resistance value, and/or the like) of battery cells 11 acquired during the observation period. In some embodiments, the cell voltage value and the internal short-circuit resistance value may be the average cell voltage value (

U̅t̅) and the average internal short-circuit resistance value (R̅l̅) during the observation period. The diagnosis device 24 may use the outlier diagnosis method as a statistical analysis method. The outlier diagnosis may detect state data having values that differ from most (e.g., a threshold number of) values by a threshold amount (e.g., values that fall outside the outlier boundary) as abnormal value.

The diagnosis device 24 may perform the outlier diagnosis on the cell voltage values (U̅t̅) of at least one of the battery cells 11, and determine an abnormality score for the cell voltage value of the battery cell 11. In some embodiments, the diagnosis device 24 may determine a cell voltage value that has an abnormality score greater than or equal to a threshold value, among the cell voltage values of the battery cells 11, as an abnormal value.

The diagnosis device 24 may perform an outlier diagnosis on the capacity values Q of at least one of the battery cells 11 and determine an abnormality score for the capacity value of the battery cell 11. In some embodiments, the diagnosis device 24 may determine a capacity value that has an abnormality score greater than or equal to a threshold value, among the capacity values of the battery cells 11, as an abnormal value.

The diagnosis device 24 may perform the outlier diagnosis on the parasitic current values Ip of at least one of the battery cells 11, and determine abnormality scores for the parasitic current values of the battery cell 11. In some embodiments, the diagnosis device 24 may determine a leakage current value that has an abnormality score greater than or equal to a threshold value, among leakage current values of the battery cells 11, as an abnormal value.

The diagnosis device 24 may perform the outlier diagnosis on the internal short-circuit resistance values (R̅l̅) of at least one of the battery cells 11, and determine an abnormality score for the internal short-circuit resistance value of the battery cell 11. In some embodiments, the diagnosis device 24 may determine a internal short-circuit resistance value that has an abnormality score greater than or equal to a threshold value, among internal short-circuit resistance values of the battery cells 11, as an abnormal value.

The diagnosis device 24 may use various methods to calculate abnormality scores, such as the Z-score test method, the modified Z-score test method, the Grubbs's test method, and/or the Q-test method.

Based on detecting a battery cell 11 having an abnormal value for one or more items or battery parameters (e.g., cell voltage, capacity, parasitic leakage current, or internal short-circuit resistance, and/or the like) through anomaly diagnosis, the diagnosis device 24 may determine the battery cell 11 as an abnormal cell having a risk of internal short-circuit.

The control device 25 may perform protective actions based on detecting an abnormal cell by the diagnosis device 24. Based on detecting the abnormal cell, the control device 25 may output a warning signal (such as an acoustic signal, a light emitting signal, or a video signal) to warn that an abnormal cell has been detected. In some embodiments, the control device 25 may transmit a diagnosis code to the upper control devices (vehicle controller, energy management system (EMS), and/or) of the system where the battery 10 is equipped, to notify the detection of the abnormal cell. The control device 25 may open the charging and discharging switch to block charging and discharging to protect battery 10 from thermal runaway, fire, and the like, due to internal short-circuit when a specific battery cell 11 is identified as an abnormal cell for a set or predetermined number of times or a set or predetermined time.

According to an embodiment, the state estimation device 23, the diagnosis device 24, and the control device 25 may be implemented by a battery management system (BMS) of a battery system where the battery 10 is equipped. In this case, the BMS may include at least one processor executing a program designed to perform the aforementioned functions of the state estimation device 23, the diagnosis device 24, and the control device 25. A processor may include a data processing device having a physically structured circuit to perform a function expressed in a code or instruction included in a program, such as a microprocessor, central processing unit (CPU), processor core, multiprocessor, ASIC (application-specific integrated circuit), and/or FPGA (field programmable gate array).

According to some embodiments, the state estimation device 23 and the control device 25 may be implemented by the BMS of the battery system, and the diagnosis device 24 may be implemented by an external device outside the battery system. In this embodiment, the diagnosis device 24 may include at least one processor executing a program designed to perform the diagnosis function described above. The diagnosis device 24 may be a higher-level control device (e.g., vehicle controller, EMS, and/or the like) of a battery system where the battery 10 is equipped. The diagnosis device 24 may also be implemented in the form of a cloud server. Additionally, in this embodiment, the state estimation device 23 and the control device 25 may communicate with the diagnosis device 24 using wired communication (e.g., UART, CAN, Ethernet LAN, SPI, I2C, and/or) or wireless communication (Wi-Fi, Bluetooth, and/or). In some embodiments, the state estimation device 23 transmits the acquired state data (cell voltage value (U̅t̅), capacity value Q, internal short-circuit resistance value (R̅l̅), and parasitic leakage current value Ip) for at least one (e.g., each) battery cell 11 to the diagnosis device 24, and the diagnosis device 24 may transmit the diagnosis result acquired through the outlier diagnosis to the control device 25. The diagnosis result may include identification information for the battery cell 11 having an abnormal value and information about the item or battery parameter (e.g., cell voltage, capacity, internal short-circuit resistance, or parasitic leakage current) for which the abnormal value was detected.

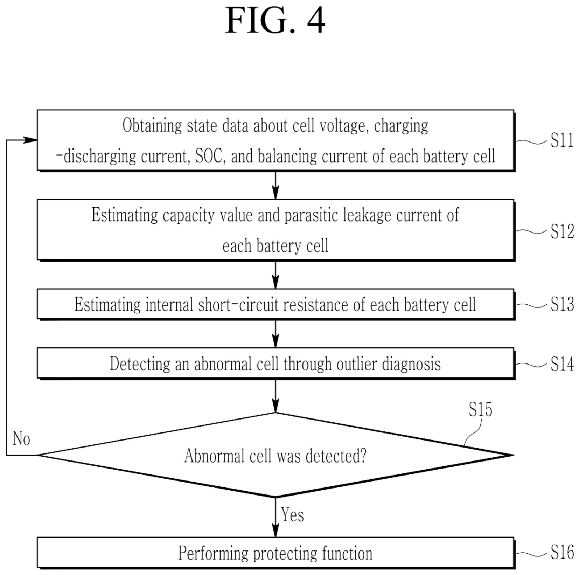

FIG. 4 depicts a flow diagram of a battery diagnosis method executed by a battery diagnosis apparatus according to an embodiment of the present invention. The method of FIG. 4 may be performed by the battery diagnosis apparatus 20 described with respect to FIG. 1.

Referring to FIG. 4, the state estimation device 23 of the battery diagnosis apparatus 20 may obtain state data on cell voltage, charging and discharging current, SOC, and balancing current of a battery cell 11 during the observation period, based on the measurement data obtained through the measuring device 22 (S11). At step S11, the state estimation device 23 may obtain the cell voltage value and measured current value (charging and discharging current value) of the battery cell 11 based on the measurement data received from the measuring device 22. In some embodiments, the state estimation device 23 may estimate the OCV value of the battery cell 11 using the cell voltage value of the battery cell 11 measured in a state that satisfies an identified or a predetermined condition, and may also estimate the SOC value of the battery cell 11 using the estimated OCV value and the SOC-OCV table. In some embodiments, the state estimation device 23 may estimate the balancing current value of the battery cell 11 based on the cell voltage value of the battery cell 11.

The state estimation device 23 may estimate the capacity value and parasitic leakage current value of the battery cell 11 during the observation period based on the state data (e.g., the SOC value, measured current value, and balancing current value) acquired through the step S11 during the set or predetermined observation period (S12). At step S12, the state estimation device 23 may derive a linear regression model to estimate the capacity value and parasitic leakage current value during the observation period for the battery cell 11 using the data collected during the observation period (e.g., the SOC value, measured current value, and balancing current value) and the above equation 4. In some embodiments, the state estimation device 23 determines the coefficients that satisfy a criterion (e.g., optimal coefficients) of the linear regression model using the least squares method, and may estimate the capacity value and parasitic leakage current value of the battery cell 11 during the observation period using the linear regression model with the determined coefficients (e.g., optimal coefficients).

The state estimation device 23 may estimate the internal short-circuit resistance value of the battery cell 11 based on the parasitic leakage current value determined for the battery cell through step S12. At step S13, the state estimation device 23 may estimate the internal resistance value during the observation period of the battery cell 11 by substituting the cell voltage value during the observation period of the battery cell 11 and the parasitic leakage current value estimated through step S12 into equation 5 above. In some embodiments, the cell voltage value of the battery cell 11 may be an average cell voltage value during the observation period, and the internal resistance value of the battery cell 11 may be an average internal resistance value during the observation period.

The diagnosis device 24 of battery diagnosis apparatus 20 may detect an abnormal cell among the battery cells 11 through outlier diagnosis on state data (e.g., the cell voltage value, SOC value, internal short-circuit resistance value, parasitic leakage current value) acquired through steps S11 to S13 (S14). At step S14, the diagnosis device 24 may detect an abnormal value among the cell voltage values of battery cells 11 through an outlier diagnosis, and determine the battery cell 11 having the abnormal value as an abnormal cell. The diagnosis device 24 may detect an abnormal value among the capacity values of battery cells 11 through the outlier diagnosis, and may determine the battery cell 11 having the abnormal value as an abnormal cell. The diagnosis device 24 may detect an abnormal value among the internal short-circuit values of battery cells 11 through the outlier diagnosis, and may determine the battery cell 11 having the abnormal value as an abnormal cell. The diagnosis device 24 may detect an abnormal value among the leakage current values of battery cells 11 through outlier diagnosis, and may determine battery cell 11 having the abnormal value as an abnormal cell.

Based on the diagnosis device 24 detecting a battery cell 11 having an abnormal value for at least one of the items or battery parameters (e.g., an abnormal cell (S15)), the control device 25 of the battery diagnosis apparatus 20 may take an action or perform the function of protecting the battery 10 (S16). At step S16, the control device 25 may output a warning signal (such as an acoustic signal, a light emitting signal, or a video signal) to warn that an abnormal cell has been detected. Based on detecting the abnormal cell, the control device 25 may transmit a diagnosis code to notify the detection of the faulty cell to the upper control apparatus of the system equipped with the battery 10.

In some embodiments, the control device 25 may block charging and discharging of the battery by opening the charging and discharging switch to protect battery 10 from thermal runaway, fire, and the like, due to internal short-circuit.

The battery diagnosis apparatus 20 according to one or more embodiments of the present invention detects abnormal cells through statistical analysis (e.g., outlier diagnosis) of state data of the battery cells 11. This statistical analysis method may be flexibly applied to the system, compared to a current art method of detecting abnormal cells by comparing (e.g., directly comparing) the state data of the battery cells 11 with a threshold value. The current art method of comparing the state data of the battery cells 11 with a threshold value may be inconvenient in that an experiment or simulation is conducted to match a modified condition and resetting the threshold value whenever the battery 10 or an environment of the system where battery 10 is applied changes. The statistical analysis method according to one or more embodiments may be applied without resetting the threshold value even if battery 10 or the environment of the system where the battery 10 is applied changes.

In some embodiments, the battery diagnosis apparatus 20 may derive a linear regression model for estimating the capacity and parasitic leakage current of the battery cell 11 using the balancing current, charging and discharging current, and SOC of the battery cell 11, and may estimate the capacity and parasitic leakage current of the battery cell 11 using the linear regression model. Therefore, it is possible to estimate the capacity and parasitic leakage current of the battery cell 11 in real time even during cell balancing or charging and discharging is on-going.

Although the present invention has been described above by limited embodiments and drawings, the present invention is not limited thereto, and various modifications and variations are possible within the technical idea of the present invention and equivalent scopes of the patent claims to be described below by a person of ordinary skill in the technical field of the present invention.

### Description of Symbols

10: battery
11: battery cell
20: battery diagnosis apparatus
21: storage device
22: measuring device
23: state estimation device
24: diagnosis device
25: control device
31: balancing circuit
32: balancing control device
41: current sensor
Rb: balancing resistor
Ri: internal short-circuit resistance
SWb: balancing switch
Ic: cell current
Im: measured current
Ib: balancing current
Ip: parasitic leakage current

## Claims

1. A battery diagnosis apparatus (20) comprising:
a measuring device (22) configured to measure a first current value flowing through a charging-discharging path of a plurality of battery cells (11), and a cell voltage value of at least one of the plurality of battery cells (11); and
at least one processor configured to estimate a second current value flowing through a balancing resistor (Rb) connected to the at least one of the plurality of battery cells (11) based on the cell voltage value, estimate a third current value flowing through an internal short-circuit resistance (Ri) of the at least one of the plurality of battery cells (11) based on the first current value, the second current value, and a change in charge state of the at least one of the plurality of battery cells (11), and detect an abnormal cell among the plurality of battery cells (11) based on the third current value of the at least one of the plurality of battery cells (11).

2. The battery diagnosis apparatus (20) as claimed in claim 1, wherein
the at least one processor is configured to derive a linear regression model for estimating the third current value based on obtaining the first current value, the second current value, and the change of the charge state during a set interval, and is further configured to estimate the third current value based on the linear regression model, optionally wherein
the at least one processor is configured to derive one or more coefficients of the linear regression model based on a least squares method.

3. The battery diagnosis apparatus (20) as claimed in claim 1 or 2, wherein
the at least one processor is configured to:
detect an abnormal value based on a statistical analysis of the third current value; and
determine the at least one of the plurality of battery cells (11) for which the abnormal value is detected as the abnormal cell.

4. The battery diagnosis apparatus (20) as claimed in any of the preceding claims, wherein
the at least one processor is configured to:
calculate an average cell voltage value for a set period for the at least one of the plurality of battery cells (11); and
calculate a second resistance value of the internal short-circuit resistance (Ri) for the at least one of the plurality of battery cells (11) based on the average cell voltage value and the third current value of the at least one of the plurality of battery cells (11).

5. The battery diagnosis apparatus (20) as claimed in claim 4, wherein
the at least one processor is configured to:
detect an abnormal value based on a statistical analysis on the second resistance value of the at least one of the plurality of battery cells (11); and
determine the at least one of the plurality of battery cells (11) for which the abnormal value is detected as the abnormal cell and/or wherein
the at least one processor is configured to:
detect an abnormal value through a statistical analysis on the average cell voltage value of the at least one of the plurality of battery cells (11); and
determine the at least one of the plurality of battery cells (11) for which the abnormal value is detected as the abnormal cell.

6. The battery diagnosis apparatus (20) as claimed in any of the claims 2 to 5, wherein
the at least one processor is configured to:
estimate a capacity value of the at least one of the plurality of battery cells (11) based on the linear regression model;
detect an abnormal value based on a statistical analysis on the capacity value of the at least one of the plurality of battery cells (11); and
determine the at least one of the plurality of battery cells (11) for which the abnormal value is detected as the abnormal cell.

7. The battery diagnosis apparatus (20) as claimed in any of the preceding claims, further comprising:
a storage device (21) storing a table representing a relationship between an open circuit voltage (OCV) and a charge state,
wherein the at least one processor is configured to:
determine the cell voltage value based on the at least one of the plurality of battery cells (11) having the first current value less than or equal to a threshold value for at least an identified amount of time, as the open circuit voltage (OCV) of the at least one of the plurality of battery cells (11);
estimate a charge state value of the at least one of the plurality of battery cells (11) based on the open circuit voltage (OCV) of the at least one of the plurality of battery cells (11) and the table; and
calculate the change of the charge state based on the charge state value.

8. The battery diagnosis apparatus (20) as claimed in any of the preceding claims, wherein
the at least one processor is included in a battery management system of a battery system where at least one of the plurality of battery cells (11) is equipped and/or wherein
the at least one processor comprises a first processor configured to estimate the third current value and a second processor configured to detect the abnormal cell;
the first processor is comprised in a battery management system (BMS) of a battery system where at least one of the plurality of battery cells (11) is equipped; and
the second processor is comprised in an external device of the battery system.

9. A battery diagnosis method performed by at least one processor, comprising:
measuring a first current value flowing through a charging-discharging path of a plurality of battery cells (11), and a cell voltage value of at least one of the plurality of battery cells (11);
estimating a second current value flowing through a balancing resistor (Rb) connected to the at least one of the plurality of battery cells (11) based on the cell voltage value;
estimating a third current value flowing through an internal short-circuit resistance (Ri) of the at least one of the plurality of battery cells (11) based on the first current value, the second current value, and a change in charge state of the at least one of the plurality of battery cells (11); and
detecting an abnormal cell of the at least one of the plurality of battery cells (11) based on the third current value of the at least one of the plurality of battery cells (11).

10. The battery diagnosis method as claimed in claim 9, wherein
the estimating the third current value comprises:
deriving a linear regression model for estimating the third current value based on the first current value, the second current value, and the change of the charge state obtained during a set period; and
estimating the third current value based on the linear regression model, optionally wherein
the deriving the linear regression model comprises deriving one or more coefficients of the linear regression model based on a least squares method.

11. The battery diagnosis method as claimed in claim 9 or 10, wherein
the detecting of the abnormal cell comprises:
detecting an abnormal value based on a statistical analysis of the third current value; and
determining the at least one of the plurality of battery cells (11) for which the abnormal value is detected as the abnormal cell.

12. The battery diagnosis method as claimed in any of the claims 9 to 11 , further comprising:
calculating an average cell voltage value for a set period for the at least one of the plurality of battery cells (11); and
calculating a second resistance value of the internal short-circuit resistance (Ri) for the at least one of the plurality of battery cells (11) based on the average cell voltage value and the third current value of the at least one of the plurality of battery cells (11).

13. The battery diagnosis method as claimed in claim 12, further comprising:
detecting an abnormal value based on a statistical analysis of the second resistance value of the at least one of the plurality of battery cells (11); and
determining the at least one of the plurality of battery cells (11) for which the abnormal value is detected as the abnormal cell and/or further comprising: detecting an abnormal value based on a statistical analysis of the average cell voltage value of the at least one of the plurality of battery cells (11); and
determining the at least one of the plurality of battery cells (11) for which the abnormal value is detected as the abnormal cell.

14. The battery diagnosis method as claimed in any of the claims 10 to 13, further comprising: estimating a capacity value of the at least one of the plurality of battery cells (11) based on the linear regression model; and
detecting an abnormal value based on a statistical analysis on the capacity value of the at least one of the plurality of battery cells (11); and
determining the at least one of the plurality of battery cells (11) for which the abnormal value is detected as the abnormal cell.

15. The battery diagnosis method as claimed in any of the claims 9 to 14, further comprising: determining the cell voltage value based on the at least one of the plurality of battery cells (11) having the first current value lower than or equal to a threshold value for at least an identified amount of time, as the open circuit voltage (OCV) of the at least one of the plurality of battery cells (11);
estimating a charge state value of the at least one of the plurality of battery cells (11) based on a table representing a relationship between the open circuit voltage (OCV) and a charge state and the open circuit voltage (OCV) of the at least one of the plurality of battery cells (11); and
calculating the change of the charge state based on the charge state value.
